**Europäisches Patentamt**

**European Patent Office**

**Office européen des brevets**

(19)

(11) Veröffentlichungsnummer: **0 117 471**
**B1**

(12) # EUROPÄISCHE PATENTSCHRIFT

(45) Veröffentlichungstag der Patentschrift:
28.10.87

(21) Anmeldenummer: **84101425.1**

(22) Anmeldetag: **11.02.84**

(51) Int. Cl.⁴: **G 01 N 27/06,** G 01 N 27/07

(54) Elektrische Leitfähigkeitsmesssonde.

(30) Priorität: **19.02.83 DE 3305784**

(43) Veröffentlichungstag der Anmeldung:
**05.09.84 Patentblatt 84/36**

(45) Bekanntmachung des Hinweises auf die Patenterteilung:
**28.10.87 Patentblatt 87/44**

(84) Benannte Vertragsstaaten:
**AT BE CH DE FR GB IT LI**

(56) Entgegenhaltungen:
**DE - A - 3 006 877**
**FR - A - 1 076 352**
**US - A - 2 810 879**

(73) Patentinhaber: **LANG APPARATEBAU GMBH,**
**Raiffeisenstrasse 7, D-8221 Siegsdorf Obb. (DE)**

(72) Erfinder: **Scheurl, Robert, Kienau 4, D-8221 Inzell (DE)**
Erfinder: **Strasser, Hans-Erwin, Lerchmoosstrasse 8a,**
**D-8227 Siegsdorf (DE)**
Erfinder: **Bödecker, Kay, Lindenstrasse 20,**
**D-8224 Chieming (DE)**

(74) Vertreter: **Bornemann, Dieter, Dipl.-Ing., c/o Henkel**
**Kommanditgesellschaft auf Aktien - Patentabteilung -**
**Postfach 1100 Henkelstrasse 67, D-4000 Düsseldorf (DE)**

**Beschreibung**

Die Erfindung betrifft eine elektrische Leitfähigkeitsmesssonde zum Einsatz in einer in einem Behälter enthaltenen, elektrisch leitenden Flüssigkeit, insbesondere in einem Reinigungsbad, mit zwei sich in der Flüssigkeit gegenüberstehenden Elektroden, die durch einen Sondensockel nach aussen geführte Elektrodenkabel besitzen und auf ein die Leitfähigkeit der Flüssigkeit durch Nachdosieren eines Zusatzmittels mit Hilfe eines zugeordneten Dosiergerätes im wesentlichen konstant regelndes Steuergerät geschaltet sind.

Solche Messsonden werden zum Überwachen der Konzentration von Reinigungsbädern, insbesondere in Waschanlagen und Geschirrspülmaschinentanks, eingesetzt. Dabei wird der sich, mit der Konzentration der Flotte ändernde elektrische Widerstand der Waschflotte gemessen. Wird die für Reinigungswirkung erforderliche Konzentration der beispielsweise aus Wasser und Reinigerkonzentrat bestehenden Waschflottenlösung unterschritten, so wird von dem der Messsonde nachgeschalteten Messgerät eine Pumpe angesteuert, z.B. über ein elektronisches Regelsystem, und Reinigerkonzentrat über eine Dosierleitung in den Behälter nachdosiert. Aus der FR-A 1 076 352 ist eine selbstreinigende elektrische Leitfähigkeitsmesssonde bekannt, bei der u.a. ein an jedem seiner Enden je eine rohrförmige Elektrode aufweisendes, die zu prüfende Flüssigkeit führendes Kunststoffrohr verwendet wird.

Ein Teil im Gebrauch befindlicher Messsonden wird im wesentlichen aus spanabhebend bearbeitetem, thermoplastischen Kunststoffhalbzeug und Elektrokohle oder Edelstahl hergestellt. Die einzelnen Bauteile werden durch Verschrauben verbunden. Die Abdichtung der elektrisch leitenden Formteile zu den isolierenden Kunststoffteilen wird meist mit Hilfe elastischer Dichtelemente vorgenommen. Die Materialien werden in der Regel so ausgewählt, dass sie den in solchen Reinigungsbädern üblicherweise vorkommenden Temperaturen von 10 bis 90°C widerstehen. Eine andere im Gebrauch befindliche Messsonde besteht aus mit Kunstharz, z.B. Polyesterharz, in einer Form umgossenen Formteilen aus Elektrokohle oder Edelmetall. Sonden dieser Bauart weisen jedoch nur eine geringe mechanische Festigkeit auf und sind unter Betriebsbedingungen, wie sie beispielsweise in einer Geschirrspülmaschine vorkommen, störanfällig. Ausserdem treten bei Betrieb wegen der unterschiedlichen thermischen Ausdehnungskoeffizienten von Metall- und Kohleformteilen einerseits und der isolierenden Kunststoff- bzw. Kunstharzhülle andererseits hohe Wärmespannungen auf, die Undichtheiten zur Folge haben können. Ein weiterer Nachteil bisher verwendeter Messsonden besteht darin, dass die Messflächen der Elektroden wegen der stark verschmutzten Waschflotten schnell verschmutzen und entsprechend häufig zu reinigen sind. Beim Reinigen ergeben sich jedoch Schwierigkeiten, da die Sonden nur zeitaufwendig und erst nach Abnahme der Anschlüsse nach dem Behälterinnern hin zu demontieren sind. Die Reinigung der Messflächen wird daher meist innerhalb des sehr beengten Waschflottenbehälters bzw. -tanks vorgenommen. Um hierbei nicht zusätzlich durch den Dosieranschluss behindert zu werden, wird dieser mit Abstand von der Sonde getrennt am Behälter angebracht.

Der Erfindung liegt die Aufgabe zugrunde, eine chemisch und thermisch beständige Messsonde mit sicherer Verbindung zwischen Isolierung und elektrischen Zuleitungen zu schaffen, die gegen Verschmutzung weitgehend geschützt ist. Ausserdem wäre wünschenswert, die Sonde so auszubilden, dass sie aus Gründen der Service-Freundlichkeit zu Kontrollzwecken einfach und ohne Abklemmen der Anschlüsse nach aussen abgezogen werden kann.

Die erfindungsgemässe Lösung ist für die Sonde eingangs genannter Art gekennzeichnet durch die Integration einer Dosierleitung in den Sondensockel und die Anordnung des Dosierausgangs der Dosierleitung im Behälter in unmittelbarer Nähe der durch die Elektroden gebildeten Messstrecke.

Durch das Integrieren der Dosierleitung in die Messsonde wird einerseits gegenüber dem separaten Anbringen an der Behälterwand Montageaufwand erspart und andererseits erreicht, dass die Messflächen der Elektroden durch die unmittelbare Nähe des Dosierrohrausgangs selbsttätig reingehalten werden. Ausserdem erhält man, bedingt durch die sehr kurze Regelstrecke, auch kurze Dosierintervalle und somit eine genaue Dosierung. Die selbstreinigende Wirkung wird dadurch erreicht, dass in dem Zeitraum beginnend mit dem Dosieren in unmittelbarer Nachbarschaft der Messstrecke bis zum Vermischen des Reinigerkonzentrats mit dem Wasser weiter ab von der Messstrecke an den Messflächen kurzfristig eine starke Überkonzentration der Reinigerlösung mit hoher Reinigungswirkung auftritt.

Vorzugsweise enthält die erfindungsgemässe Messsonde solche aktiven Einlegeteile, die passend positioniert in einer Werkzeugform im Spritzgussverfahren mit thermoplastischem Kunststoff nach aussen formgebend und zueinander isolierend zu umhüllen sind, derart, dass der Dosierrohrausgang und die freien Messflächen so nahe wie möglich benachbart liegen und die Elektrodenkabel-Durchführung sowie die Dosierleitung sich an einer Stirnseite der Messsonde befinden. In diesem Sinne ist es gemäss einer weiteren Weiterbildung der Erfindung auch möglich und besonders vorteilhaft, den die Elektroden und den Dosierausgang enthaltenden Sondenteil als Steckbuchse zum lösbaren Einsetzen in eine Einbauarmatur der Behälterwand auszubilden. Die Sonde kann dann beispielsweise mit Hilfe einer Druckschraube in der Einbauarmatur festgelegt werden und nach Lösen der Druckschraube zu Kontrollzwecken problemlos nach aussen abgezogen werden.

Anhand der schematischen Zeichnung werden Einzelheiten der Erfindung erläutert.

Die Messsonde gemäss Ausführungsbeispiel wird durch eine im Spritzgussverfahren hergestellte, elektrisch isolierende, thermoplastische Kunststoffhülle 1 zusammengehalten. In der Kunststoffhülle 1 werden die Einlegeteile, wie Dosierrohr 2, Zentrierstück 3, Elektroden 4 und Elektrodenkabel 5, dichtend umschlossen. Nur die Messflächen 6 der Elektroden 4, der Dosierrohrein- und -ausgang 7 bzw. 8 und die Elektrodenkabeldurchführung 9 mit umgebender Knickschutzhülle 10 treten aus der Oberfläche der Kunststoffhülle 1 hervor. Die so beschriebene Sonde wird in eine in die Behälterwand 15 gesetzte Einbauarmatur 11 mit Hilfe einer Druckschraube 13 festgelegt. Zum Abdichten dienen Dichtelemente 12 und 14.

Die selbstreinigende Wirkung der erfindungsgemässen Sonde wird dadurch erreicht, dass das beim Dosieren in Pfeilrichtung 17 in die Waschflotte 16 eintretende Reinigungsmittel im Bereich zwischen den Elektroden 4 vorübergehend zu einer starken Überkonzentration führt, derart, dass die Messflächen 6 und der übrige Bereich der in die Waschflotte 16 eintauchenden Sondenteile besonders intensiv gereinigt werden.

Für Herstellung und Anwendung ist es besonders günstig, wenn die Sonde im wesentlichen zylindrisch ausgebildet wird. Eine günstige Montage ergibt sich, wenn die Sonde in ihrem rückwärtigen in der Einbauarmatur 11 verbleibenden Bereich eine Schulter 18 besitzt, die beim Einsetzen in die Einbauarmatur 11 unter Zwischenlage des Dichtelements 12 gegen eine entsprechende Schulter 19 der Einbauarmatur 11 stösst. Ein Herausfallen der Sonde aus der Einbauarmatur 11 wird ausgeschlossen, wenn die Sonde eine weiter Schulter 20 aufweist, gegen die die in ein in der Einbauarmatur 11 eingebrachtes Gewinde 21 zu schraubende Druckschraube 13 bei der Montage stösst.

Bezugszeichenliste
1 = Thermoplastische Kunststoffhülle
2 = Dosierrohr
3 = Zentrierstück
4 = Elektroden
5 = Elektrodenkabel
6 = Messflächen der Elektroden
7 = Dosierrohreingang
8 = Dosierrohrausgang
9 = Elektrodenkabel-Durchführung
10 = Elastische Knickschutztülle
11 = Einbauarmatur
12 = Dichtelement, innen
13 = Druckschraube
14 = Dichtelement, aussen
15 = Tankwand
16 = Waschflotte
17 = Fliessrichtungspfeile
18 = Schulter (1)
19 = Schulter (11)
20 = Schulter (1)
21 = Gewinde (11)

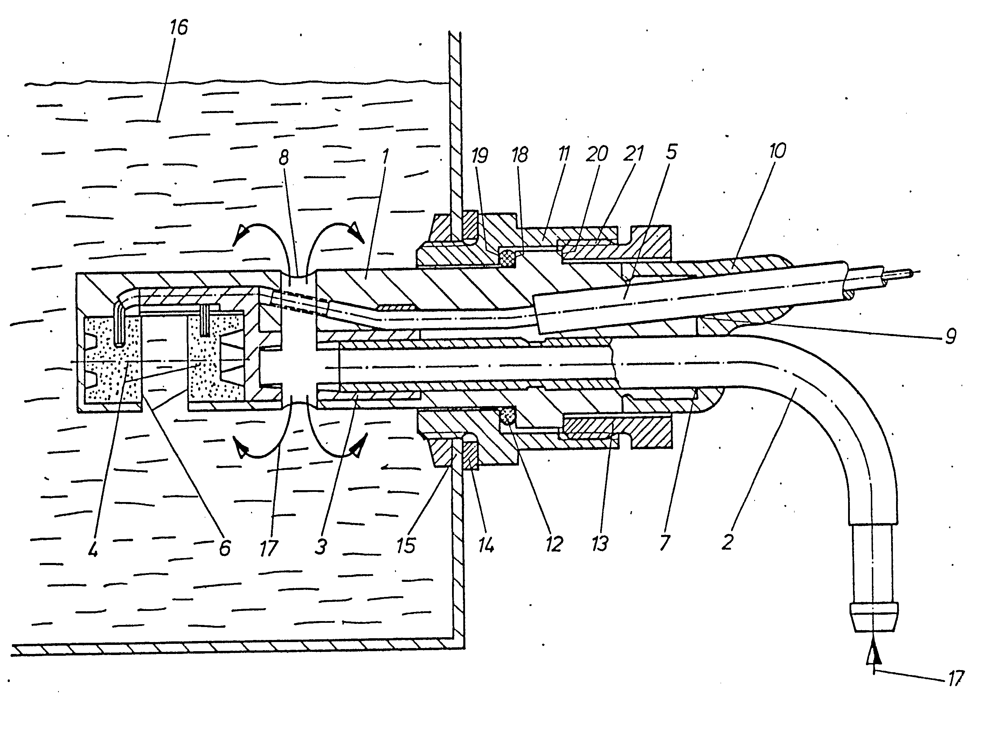

**Patentansprüche**

1. Elektrische Leitfähigkeitsmesssonde zum Einsatz in einer in einem Behälter (15) enthaltenen, elektrisch leitenden Flüssigkeit (16), insbesondere in einem Reinigungsbad, mit zwei sich in der Flüssigkeit (16) gegenüberstehenden Elektroden (4), die durch einen Sondensockel nach aussen geführte Elektrodenkabel (5) besitzen und auf ein die Leitfähigkeit der Flüssigkeit durch Nachdosieren eines Zusatzmittels mit Hilfe eines zugeordneten Dosiergeräts im wesentlichen konstant regelndes Steuergerät geschaltet sind, gekennzeichnet durch die Integration einer Dosierleitung (2) in den Sondensockel und die Anordnung des Dosierausgangs (8) der Dosierleitung (2) im Behälter (15) in unmittelbarer Nähe durch die Elektroden (4) gebildeten Messstrecke.

2. Messsonde nach Anspruch 1, dadurch gekennzeichnet, dass sich die Elektrodenkabel-Durchführung (9) und die Dosierleitung (2) an der dem Behälterinneren abgewandten Stirnseite der Messsonde befinden und dass der die Elektroden (4) sowie den Dosierausgang (8) enthaltende Sondenteil als Steckteil zum lösbaren Einsetzen in eine die Behälterwand durchdringende, buchsenförmige Einbauarmatur (11) ausgebildet ist.

3. Messsonde nach Anspruch 1 oder 2, dadurch gekennzeichnet, dass die aktiven Teile (2, 3, 4, 5, 7, 8) der Messsonde, abgesehen von den Messflächen (6) der Elektroden (4), mit thermoplastischem Kunststoff, insbesondere nach dem Spritzgussverfahren umhüllt sind, wobei die äussere Form der Messsonde und eine gegenseitige Isolierung der aktiven Teile (2, 3, 4, 5, 7, 8) erreicht wird.

**Claims**

1. Electrical conductivity measuring probe for use in an electrically conducting liquid (16) contained in a container (15), in particular in a cleaning bath, with two electrodes (4), which each stand opposite the other in the liquid (16), possess electrode cables (5) led outwardly through a probe socket and are wired to a control device regulating the conductivity of the liquid to be substantially constant through replenishment by metering an additive medium with the aid of an associated metering device, characterised by the integration of a metering duct (2) into the probe socket and the arrangement of the metering outlet (8) of the metering duct (2) in the container (15) in immediate proximity of the measuring path formed by the electrodes (4).

2. Measuring probe according to claim 1, characterised thereby, that the electrode cable feedthrough (9) and the metering duct (2) are disposed at that end face of the measuring probe, which is remote from the interior of the container, and that the probe part containing the electrodes (4) as well as the metering outlet (8) is constructed as plug part for the detachable insertion into a sleeve-like adapter fitting (11) penetrating the container wall.

3. Measuring probe according to claim 1 or 2, characterised thereby, that the active parts (2, 3, 4, 5, 7, 8) of the measuring probe, apart from the measuring surfaces (6) of the electrodes (4) are enveloped by thermoplastic synthetic material, particularly by an injection-moulding process, wherein the external shape of the measuring probe and a mutual insulation of the active parts (2, 3, 4, 5, 7, 8) is attained.

**Revendications**

1. Sonde de mesure de conductivité électrique conçue pour une utilisation dans un liquide conducteur de l'électricité (16) contenu dans un récipient (15), en particulier dans un bain de nettoyage, cette sonde étant pourvue de deux électrodes (4) opposées plongeant dans le liquide (16) et qui sont pourvues de cables d'électrodes (5) conduits vers l'extérieur à travers le socle de la sonde et branchés sur un dispositif de commande règlant de façon pratiquement constante la conductivité du liquide par addition dosée d'un additif à l'aide d'un dispositif doseur adjoint, sonde caractérisée par le fait qu'elle comporte un tuyau de dosage (2) intégré dans son socle et que la sortie de dosage (8) de ce tuyau de dosage (2) dans le récipient (15) est située à proximité immédiate du parcours de mesure formé par les électrodes (4).

2. Sonde de mesure selon la revendication 1, caractérisée par le fait que la traversée des câbles d'électrode (9) et du tuyau de dosage (2) se trouve dans son côté frontal qui est opposé à l'intérieur du récipient et que sa partie de sonde, contenant les électrodes (4) ainsi que la sortie de dosage (8) est conçue sous forme d'un élément enfichable pour pouvoir être introduite de manière amovible dans un accessoire d'installation (11) en forme de douille traversant la paroi du récipient.

3. Sonde de mesure selon l'une ou l'autre des revendications 1 ou 2, caractérisée par le fait que ses parties actives (2, 3, 4, 5, 7, 8), abstraction faite des surfaces de mesure (6) des électrodes (4), sont enveloppées de matière synthétique thermoplastique, en particulier selon le procédé de moulage par injection, de manière que sa forme extérieure et une isolation mutuelle de ses parties actives (2, 3, 4, 5, 7, 8) soient atteintes.